# EUROPEAN PATENT SPECIFICATION

(11) **EP 4 270 427 B1**
(45) Date of publication and mention of the grant of the patent: **04.11.2026**
(21) Application number: 22170051.1
(22) Date of filing: 26.04.2022
(51) Int. Cl.: H01G 2/02, H01G 2/04, H01G 2/10, H05K 3/30, H05K 3/34, H05K 5/00, H05K 7/12, H01G 2/06

(54) **MOUNTING STRUCTURE FOR A CAPACITOR AND METHOD FOR ASSEMBLING A CAPACITOR TO A MOUNTING STRUCTURE**
MONTAGESTRUKTUR FÜR EINEN KONDENSATOR UND VERFAHREN ZUM MONTIEREN EINES KONDENSATORS AN EINER MONTAGESTRUKTUR
STRUCTURE DE FIXATION POUR UN CONDENSATEUR ET PROCÉDÉ D'ASSEMBLAGE D'UN CONDENSATEUR SUR UNE STRUCTURE DE FIXATION

(43) Date of publication of application: 01.11.2023
(73) Proprietor: Veoneer Sweden Safety Systems AB, 10302 Stockholm (SE)
(72) Inventor: CACU, Adrian, 700051 Iasi (RO); ZAMFIR, Marius, 700051 Iasi (RO)
(74) Representative: Reichert & Lindner Partnerschaft Patentanwälte

(56) References cited:
- EP-A1- 3 866 573
- DE-A1- 102011 114 965
- DE-A1- 102016 206 930
- US-A1- 2009 257 199
- US-A1- 2019 006 101

## Description

### FIELD OF THE INVENTION

The invention relates to a mounting structure for a capacitor in a housing part. The mounting structure comprises a plurality of components, which are an arc shaped guide, pairwise arranged support elements, an alignment support, at least one pair of holding elements, a limit stop and a seat for each electric lead of the capacitor. All components are formed on a bottom of a housing part.

Additionally, the invention relates to a method for mounting a capacitor to a mounting structure of a housing part.

### DESCRIPTION OF THE BACKGROUND ART

EP 3 240 375 A1 relates to an electronic module for an actuator that can be used in a motor vehicle. The printed circuit board of the electronic module carries at least one cylindrical capacitor and is spaced apart by means of a holding element. The holding element has elastic biased holder cams. The elastic holder cams hold the cylindrical capacitor in a force-fit manner.

DE 10 2012 002 525 A1 discloses a housing structure for a capacitor. The housing structure has a housing base that is provided with a fastening bolt for fastening a housing portion in a slot or for inserting a holder or a plate in an elongated recess. A dimension-side complementary web is extended from the housing base by a surface of the fastening bolt to fix the housing portion in a precise position and to secure against rotation. The fastening bolt is provided with a partially circumferential cantilever portion.

CN 207818380 U discloses an electrolytic capacitor mount.

CN 210575548 U discloses a capacitor installation structure comprising a fixed frame which is an insulator. The fixed frame is fixed on a circuit board. The fixing frame is rectangular, and the shape of the fixing frame is matched with the shape of the capacitor. The capacitor is clamped in the fixed frame. Clamping devices for fixing the capacitor are symmetrically arranged on the inner wall of the fixing frame. The clamping devices are insulators, and each clamping device comprises an elastic component.

US 2018/242460 A1 describes a connector module for connecting an energy store to a printed circuit board. The connector module is designed in such a way as to receive at least two electrolytic capacitors as energy stores. The connections of the electrolytic capacitors are located at the respective ends of the longitudinal extent of the connector module.

CN 211 828 480 U discloses a fixing structure and an air conditioner compressor assembly, the fixing structure is used for fixing a part to be installed, and the fixing structure comprises an installation plate and a fixing support. The fixing support comprises a base arranged on the mounting plate. A capacitor is fixed through the accommodating space formed by closing the base, the first locking arm and the second locking arm, so that a mode of fixing the capacitor by matching a fixing clamp with a screw is avoided.

JP 2005 123307 A provides a mounting structure for a capacitor with which the capacitor in an arbitrary shape can easily and securely be fix on a substrate. A fixture having a fitting leg and a band connected to the fitting leg is used. The band is wound to the capacitor and the fitting leg and the capacitor are fixed. The fixation with the band is not easy to handle.

US 2009/257199 A1 discloses a connection between an electrolytic capacitor and a circuit board. The capacitor is in a spaced apart manner from the board. The connector module for the capacitor comprises a body with fingers and support members that engage and support the capacitor. The body may feature a plurality of legs, each leg includes spaced-apart members which fit into respective holes in the board. The module has to be produced in a separate process and the support members are not an integral part of a housing part.

As known, an electrical control unit (ECU) is an embedded electronic device. A typical ECU consists of a printed circuit board (PCB), a housing, a cover and, in some cases, a backup power unit. It must be ensured that the ECU is supplied with power even in cases where the main power unit has a malfunction. For this reason, the backup power unit is provided, which is often a relatively heavy capacitor. In the case of plastic housings, the fixation of the backup power unit is realized via a mounting structure, also called "cradle", with a plastic snap-fit solution. The mounting structure is integrated in a plastic housing part.

To keep the capacitor in place with prior art devices, the mounting structure (cradle) simply relies on the interference between the holding elements (plastic snaps) and the capacitor, which means that the holding elements will be loaded with an elastic force to provide the necessary retention force.

The capacitor is assembled in the housing part through a top opening of the holding elements (snaps), by deflecting them outside. The housing is rested on its top surface, so the assembling is done along the Z -direction of the module.

In theory, the prior art concept works sufficiently well. But in reality, when considering all the tolerances of the diameter of the capacitor, the interference can transform into a gap which may lose the capacitor or cause a rattle noise. In case the diameter of the capacitor is too big, the interference may translate in over-stressed holding elements (snaps) which may cause plastic or permanent deformations, creep, fractures etc. of the holding elements. The largest tolerance that ensures that the interference remains within a reasonable interval is the capacitor tolerance.

### SUMMARY OF THE INVENTION

It is an object of the present invention to provide a mounting structure for a capacitor which can easily and efficiently accommodate even large tolerances of the capacitor diameter and distance between the holding elements, while providing similar performance of the mounting structure from the minimum worst case (capacitor diameter on minimum and distance between holding elements on maximum) to the maximum worst case (capacitor diameter on maximum and distance between holding elements cradle on minimum).

The above object is achieved by a mounting structure for a capacitor in a housing part according to the features of claim 1.

A further object of the present invention is to provide a method for assembling a capacitor to a mounting structure which can be carried out easily and allows a defined fixation by the mounting structure even at large tolerances of the capacitor diameter and distance between the holding elements, while providing similar performance of the mounting structure from the minimum worst case (capacitor diameter on minimum and distance between holding elements on maximum) to the maximum worst case (capacitor diameter on maximum and distance between holding elements cradle on minimum).

The above object is achieved by a method for mounting a capacitor to a mounting structure of a housing part according to the features of claim 9.

According to an embodiment of the present invention, a mounting structure for a capacitor to a housing part comprises an arc shaped guide, a plurality of pairwise arranged support elements, an alignment support, at least one pair of holding elements, a limit stop and a seat for each electric lead of the capacitor. All these features of the mounting structure are formed on a bottom of a housing part and are integral parts of the housing part. The mounting structure for mounting the capacitor has a chamfer at a free end of an arc shaped guide, wherein the arc shaped guide is formed in the bottom of the housing part. Additionally, a chamfer is provided at each of the pairwise arranged support elements, which adjoin the arc shaped guide on both sides. Furthermore, a chamfer is formed at each of the at least one pair of holding elements and a chamfer is provided at the alignment support.

The advantage of the invention is that with the aid of the chamfers it is possible to smoothly insert the capacitor along its axis, electric leads first, between the holding elements. The insertion of the capacitor between the holding elements does not overstress the holding elements and avoids any plastic (permanent) deformations, creep, fractures etc. of the holding elements.

According to a further embodiment of the invention, a chamfer is at each seat for each electric lead of the capacitor. The capacitor is inserted in the mounting structure along its axis with the electric leads first. The chamfers at the seats help to avoid lead stumbling. Bigger chamfers or alternative features may be used to better guide the leads into the seats.

According to a preferred embodiment, all the chamfers of the mounting structure face in the direction of the free end of the arc shaped guide. The advantage of this orientation is that the chamfers help to guide the capacitor in the mounting structure and the electric leads into the seats.

According to a further embodiment, the arc shaped guide is arranged between the at least one pair of holding elements and stretches from the chamfer of the arc shaped guide to the alignment support. The arc shaped guide is moulded-in the bottom of the housing part. According to the invention, adjacent to the sides of the arc shaped guide, support elements are provided pairwise and a surface form of the arc shaped guide continues into a surface form of the support elements.

The advantage of the embodiment of the invention is that the surface form of the arc shaped guide and the surface form of the support elements match the outer surface form of the capacitor. Furthermore, once the capacitor is fully inserted, the capacitor is at least in form fitting contact with the outer surface form of the capacitor and the support elements provide a further side stability for the capacitor during the insertion process and when the capacitor is positioned by the mounting structure.

According to a further embodiment, only a single pair of holding elements are part of the mounting structure. The advantage of the single pair of holding elements is that a smaller top opening (for example 11.6 mm in the proposed embodiment) of holding elements will not allow the capacitor to escape from the holding elements, even under the harshest test condition. It is to be noted that the new design does not change the complexity of the housing part as the undercut of the holding elements cooperates with the capacitor as known from prior art mounting structures.

According to a further embodiment, the limit stop, as provided on the bottom of the housing part, is a stop for the capacitor when inserted between the at least one pair of holding elements. Once the free end of the capacitor is in contact with the limit stop, the alignment support engages a circumferential notch of the capacitor.

The advantage of the interaction between the circumferential notch of the capacitor and the alignment support (T-shaped rib) is that the capacitor receives a spatial stability in the X-direction.

When the front end of the capacitor reaches the alignment support, a chamfer (small ramp) helps the capacitor not to stumble and climb the little step. The holding elements are elastic and allow the front end of the capacitor to pass the small obstacle, and once the circumferential notch of the capacitor reaches the alignment support, the elastic force stored in the holding elements forces the capacitor to return into contact with the surface of the support elements and the surface of the arc shaped guide. The capacitor reaches the final position by being with its front end in contact with the limit stop.

A method for mounting a capacitor to a mounting structure of a housing part comprises several steps. Initially, the housing part is placed on a jig surface so that a bottom of the housing part is perpendicular to the jig surface.

The capacitor is moved along an X-direction with the electric leads first. With the help of a chamfer at a free end of an arc shaped guide, the chamfers of the support elements and the chamfers of the at least one pair of holding elements of the mounting structure, the capacitor is centred with respect to the mounting structure and slides without stumbling in the mounting structure. The capacitor insertion is carried out along its axis, which is parallel to the X-direction.

With the further assembly step, the capacitor is moved in the X-direction between the at least one pair of holding elements towards a limit stop. This movement is possible because the holding elements are elastic. As the capacitor moves along, according to the invention, the holding elements deflect a bit in antipodal Y-directions to create space for the ongoing insertion of the capacitor between the holding elements. In case there is a single pair of holding elements, they are designed to deform elastically and provide sufficient restoring force to hold the inserted capacitor in place.

The assembly process ends once the capacitor abuts at a limit stop of the mounting structure at the bottom of the housing part. At this moment, an alignment support of the mounting structure of the housing part engages a circumferential notch of the capacitor. The advantage is that the alignment support (T-shaped rib) still prevents the axial slipping of the capacitor in case of a drop test.

According to an embodiment of the inventive method, the capacitor needs to move up a chamfer of the alignment support (small ramp), which is part of the mounting structure of the housing part. The alignment support of the capacitor is forced by the elastic force, stored in the holding elements, so that the alignment support gets into contact with the circumferential notch of the capacitor once the front end of the capacitor touches the limit stop.

Additionally, the electric leads of the capacitor are guided via chamfers at each seat into each seat.

The advantage of the capacitor assembling is that, with the help of the chamfers, the capacitor will slide smoothly toward the holding elements and the alignment support. As the capacitor moves along the guide, the holding elements deflect a bit to create space for the insertion of the capacitor.

The insertion of the capacitor along the X-direction, which is parallel to the axis of the capacitor, with the electric leads first, provides the advantage that the capacitor can be moved between the at least one pair of holding elements. According to an embodiment, the mounting structure requires only a single pair of holding elements. This is considered sufficient as the smaller distance (opening) between the top of the pairwise arranged holding elements does not allow the capacitor to escape from the holding elements even under the harshest test condition.

The advantage of the present invention is to provide a solution that can easily and efficiently accommodate the big tolerances of the capacitor diameter and the distance (opening) between the holding element at their top. The performance of the inventive mounting structure is similar for the minimum worst case (capacitor with the minimum diameter value and holding elements with the maximum distance value) and for the maximum worst case (capacitor with the maximum diameter value and holding elements with the minimum distance value).

### BRIEF DESCRIPTION OF THE DRAWINGS

The numerous advantages of the disclosure may be better understood by those skilled in the art by reference to the accompanying figures in which:
Figure 1 shows a schematic representation of the placement of an electronic control unit (ECU) in a vehicle.
Figure 2 is a perspective view of an embodiment of a prior art capacitor cradle (for example, being an integral part of a plastic housing).
Figure 3 is a perspective, sectional view along line A-A of Fig. 2, wherein a capacitor is placed in the prior art cradle.
Figure 4 is a perspective view of a process for mounting a capacitor to a prior art mounting structure (cradle).
Figure 5 is a front, sectional view along line A-A of Fig. 2, wherein a capacitor with a minimum allowed diameter tolerance is placed in the prior art cradle.
Figure 6 is a front, sectional view along line A-A of Fig. 2, wherein a capacitor with a maximum allowed diameter tolerance is placed in the prior art cradle.
Figure 7 is a table showing the pull-out force of capacitors having different diameters.
Figure 8 is a table showing the resulting snap force of holding elements of a mounting structure (cradle) in a Y-direction, wherein the capacitors have different diameters.
Figure 9 is a perspective view of an embodiment of the mounting structure (cradle) being an integral part of a plastic housing according to the present invention.
Figure 10 an enlarged perspective view of the mounting structure (cradle) as shown in Fig. 9 with chamfers for guiding the capacitor.
Figure 11 is an enlarged side view of the capacitor during the insertion process in the mounting structure (cradle).
Figure 12 is an enlarged side view of capacitor which is in the end position in the cradle.
Figure 13 is a perspective view of a capacitor in a mounting position relative to the mounting structure.

### DETAILED DESCRIPTION

In the ensuing description, numerous specific details are provided to enable maximum understanding of the embodiments that are provided by way of example. The embodiments may be implemented with or without specific details, or else with other methods, components, materials, etc. In other circumstances, well-known structures, materials, or operations are not illustrated or described in detail so that various aspects of the embodiments will not be obscured. Reference in the course of the present description to "an embodiment" or "one embodiment" means that a particular structure, peculiarity, or characteristic described in connection with its implementation is comprised in at least one embodiment. Hence, phrases such as "in an embodiment" or "in one embodiment" that may recur in various points of the present description do not necessarily refer to one and the same embodiment. Furthermore, the particular structures, peculiarities, or characteristics may be combined in any convenient way in one or more embodiments.

Same reference numerals refer to same elements or elements of similar function throughout the various figures. Furthermore, only reference numerals necessary for the description of the respective figure are shown in the figures. The shown embodiments represent only examples of how the invention can be carried out. This should not be regarded as a limitation of the invention.

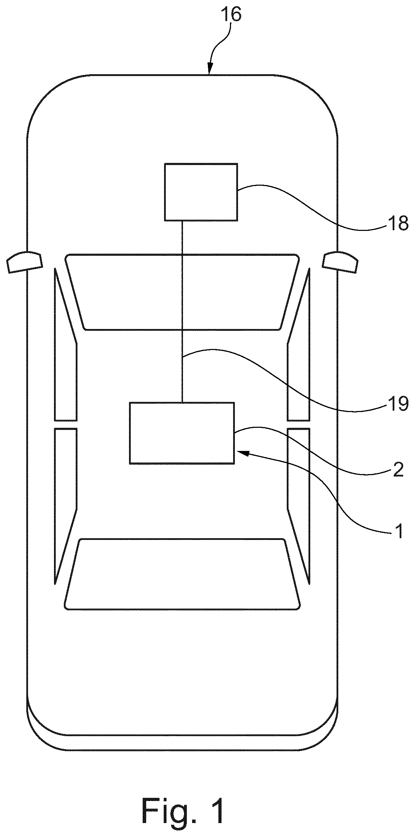

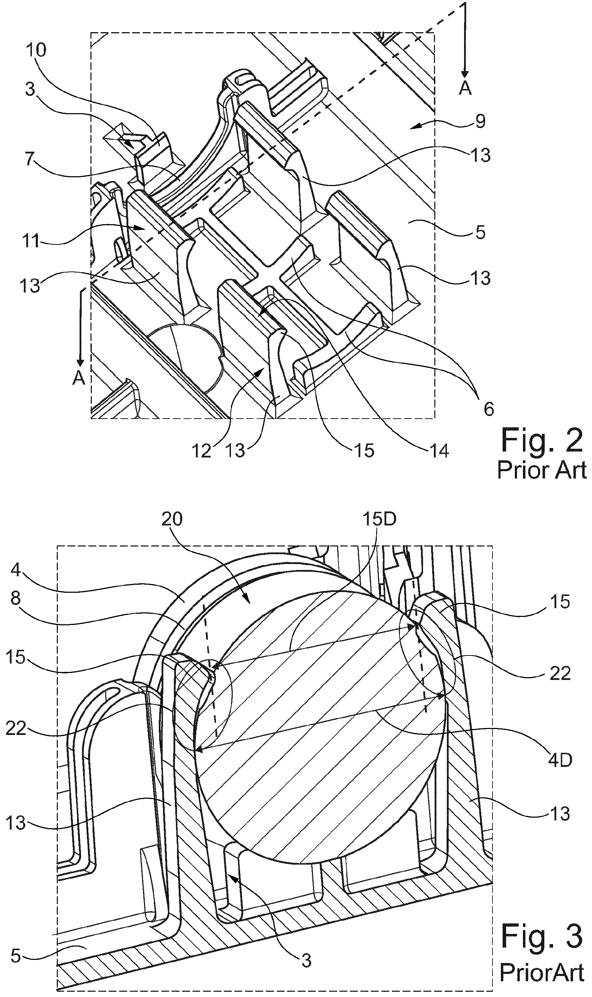

**Figure 1** shows a schematic representation of an embodiment of a placement of an electronic control unit (ECU) **1** for a vehicle **16.** Electronic control unit **1** controls one or more electrical systems of vehicle **16** and is enclosed by a housing **2.** Housing **2** may be made of plastics or metallic materials. In cases where vibrations are more extreme during use of vehicle **16,** housing **2** may be made of metallic materials, such as die-cast aluminium. To supply electrical power to ECU **1,** ECU **1** is electrically connected to a vehicle battery **18** (main battery), typically by an electric line **19.** In order to ensure a durable supply of electric power to the ECU 1 backup power unit, which is a capacitor (see Fig. 3). The relatively heavy capacitor must be mounted in the housing 2 of the ECU 1, so that backup power supply is guaranteed in all traffic situations.

**Figure 2** shows a perspective view of an embodiment of a prior art mounting structure **3** (cradle) for a capacitor **4** (see Fig. 3). In the embodiment shown here, the mounting structure **3** is an integral part of a housing part **9.** In case the housing part **9** is made of plastic, the mounting structure **3** is formed during the injection moulding process to the housing part **9.** The mounting structure **3** has several support surfaces **6,** which are provided on a bottom **5** of housing part **9.** An alignment support **7** is as well an integral part of the mounting structure **3.** Once the capacitor **4** is positioned in the mounting structure **3,** the alignment support **7** is in a form fitting contact with a circumferential notch **8** (see Fig. 3) of capacitor **4.** Circumferential notch **8** enables a correct positioning of capacitor **4** in the mounting structure **3.**

At least a first pair **11** and a second pair **12** of holding elements **13** extend upright from the bottom **5** of mounting structure **3** or the bottom of housing part **9.** A nose **15** is provided at a free end **14** of each holding element **13.** The noses **15** of the first pair **11** of holding elements **13** and the noses **15** of the second pair **12** of holding elements **13** face each other. The holding elements **13** are elastic and keep the capacitor **4** in place. The kind of mounting structure 3, shown here, simply relies on the interference between the holding elements **13** (e.g., plastic snaps) and the capacitor **4,** which means that the holding elements **13** of the mounting structure **3,** loaded with an elastic force by the insertion of capacitor **4** into cradle **3,** provide a necessary retention force for capacitor **4.**

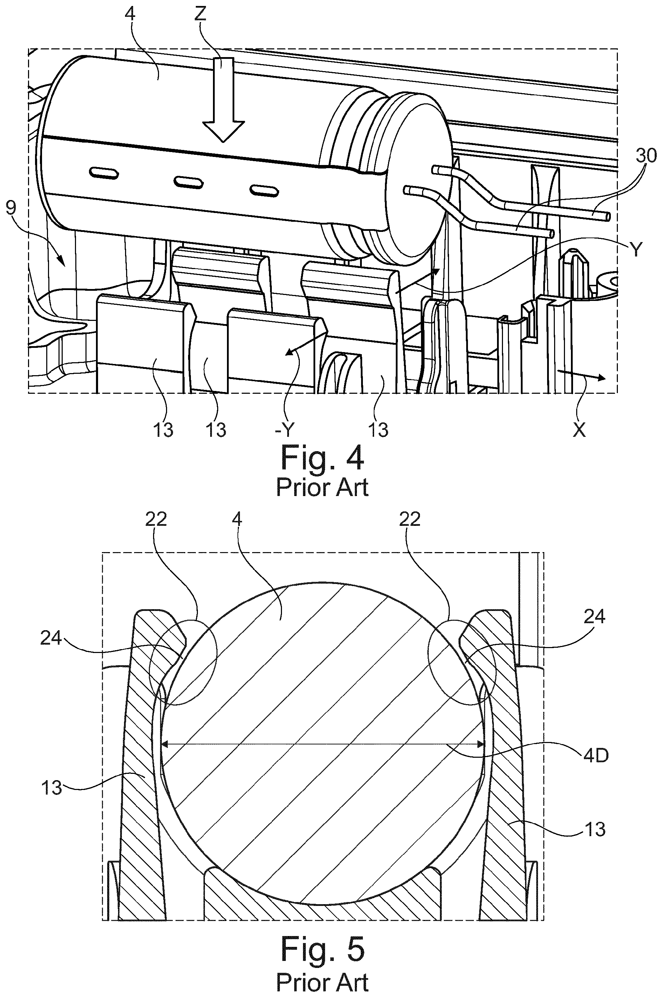

**Figure 3** is a perspective, sectional view along line A-A of Fig. 2, wherein capacitor **4** is placed in prior art mounting structure **3.** Here, only the noses **15** of the two opposing holding elements **13** of the first pair **11** of holding elements **13** are shown. The noses **15** of the two opposing holding elements **13** are spaced apart at a distance **15D,** even with the inserted capacitor **4,** which has a diameter smaller than diameter **4D** of capacitor **4.** During the insertion of capacitor **4** into mounting structure **3,** the two opposing holding elements **13** are pushed apart, and once capacitor **4** is in its final position, as shown here, the opposing holding elements **13** exert a retention force on a surface **20** of capacitor **4.** Accordingly, a portion of each holding element **13** abuts against the surface **20** of capacitor **4,** in particular, against surface **20** in the marked areas **22** in Fig. 3. In theory, the prior art concept works great. But, in reality, when considering all the tolerances (capacitor **4** diameter **4D** or distance between two opposing holding elements **13),** the above mentioned tolerances can transform into a gap (see Fig. 5) which loose the capacitor **4** and cause rattle, noise etc. - or in case of too big tolerance deviations (see Fig. 5) can translate in over-stressed holding elements **13** (plastic snaps) in plastic (permanent) deformations, creep, fractures or the like.

**Figure 4** shows a perspective view of mounting a capacitor **4** to a prior art mounting structure **3** (cradle). The capacitor **4** with its electric leads **30** is assembled to the housing part **9** though the distance **15D** of the holding elements **13** (snaps), by deflecting the holding elements **13** outside in Y-direction **Y** and opposite Y-direction **-Y.** The housing part **9** is rested on its bottom **5,** so the assembling of the capacitor **4** between the holding elements **13** is done along the Z-direction **Z** of the housing part **9.**

In theory, the above concept works great. But in reality, when considering the tolerances of diameter **4D** (see Fig. 3) of capacitor **4,** the abutment of each holding element **13** can transform into a gap **24** as shown in **Figure 5** by marked areas **22.** Here, the diameter **4D** of capacitor **4** is at a minimum, and consequently the capacitor **4** can become loose, cause a rattling noise, or the like.

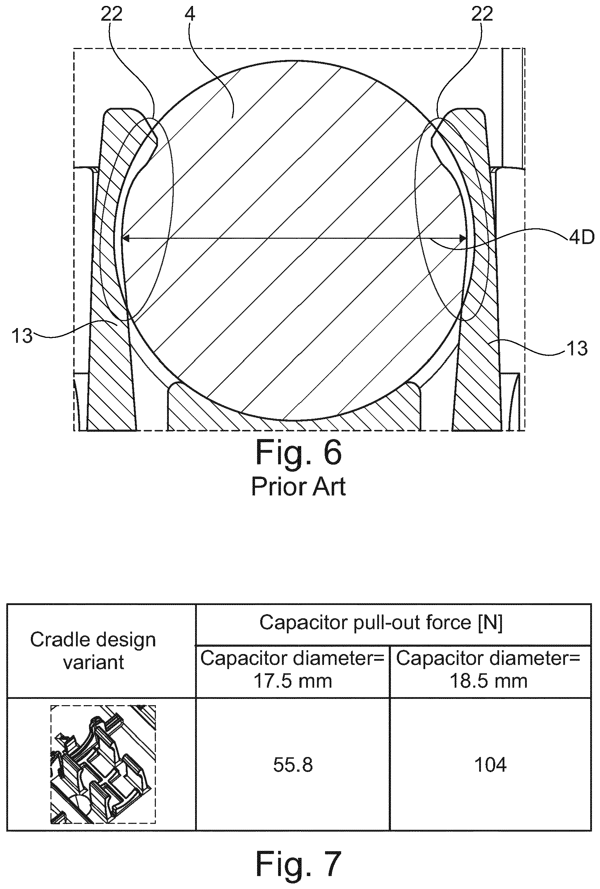

**Figure 6** shows the situation in which the diameter **4D** of capacitor **4** is at a maximum. Consequently, the interference or the abutment of the opposing holding elements **13** translate in over-stressed holding elements **13,** plastic (permanent) deformations, creep, fractures, or the like, of holding elements **13.** The areas with over-stress between capacitor **4** and holding elements **13** are the marked areas **22.** In contrary to Fig. 5, no gap **24** is formed.

**Figure 7** represents a table, showing the pull-out force of a capacitor **4** from the prior art mounting structure **3** design (cradle design) as shown in the presented table. The considered mounting structure **3** has the minimum distance **15D** of 14.8 mm between the noses **15** of the first pair **11** and second pair **12** of opposing holding elements **13.** For the determination of the pull-out force for capacitor **4,** the two worst cases of the diameter 4D of capacitor **4** were considered (minimum diameter = 17.5 and maximum diameter = 18.5mm). The capacitor **4** pull-out force is almost half for the capacitor **4** minimum diameter **4D** compared with the capacitor **4** with the maximum diameter **4D.**

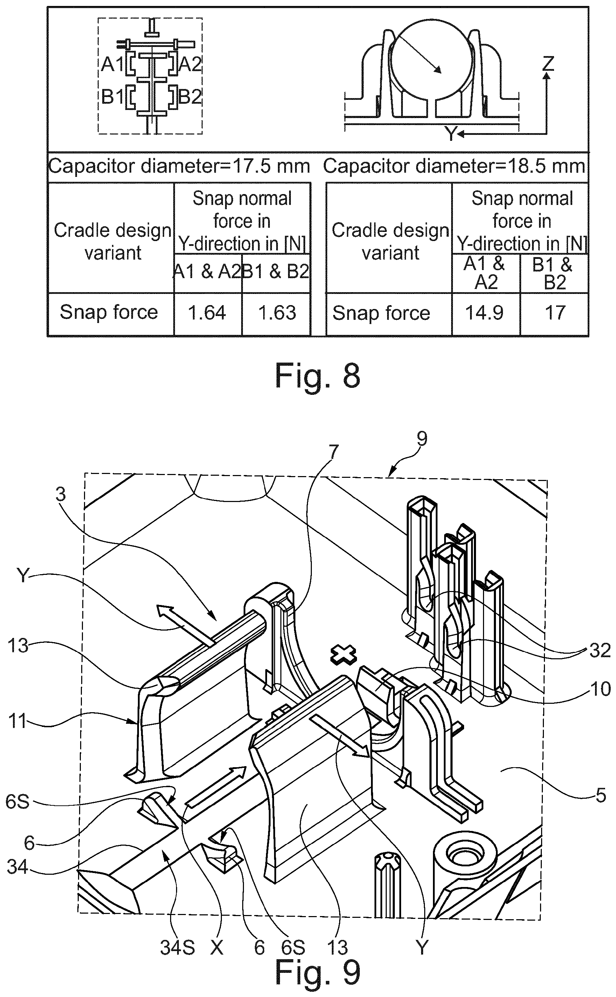

**Figure 8** is a table showing the resulting snap force of holding elements **13** (snaps) of a mounting structure (cradle) **3** in a Y-direction, wherein the snap force is calculated with a capacitor **4** of differing diameters **4D.** The normal force (snap force) between the opposing holding elements **13** (snaps) and the capacitor **4** is considerable for the capacitor **4** with maximum diameter **4D.** The normal force between the opposing holding elements **13** A1 and A2 results in 14.9N and between the opposing holding elements **13** B1 and B2 results in 17N. For the capacitor **4** with the minimum diameter **4D,** the normal force between the opposing holding elements **13** A1 and A2 results in 1.64N and between the opposing holding elements **13** B1 and B2 results in 1.63N. The low forces which exist if a capacitor **4** with the minimum diameter **4D** is mounted in the mounting structure **3** (cradle) will cause the capacitor **4** to rattle at low frequency and thus causing the module to resonate.

**Figure 9** is a perspective view of an embodiment of the mounting structure **3** (cradle) according to the present invention. The embodiment of mounting structure **3** shown here has only a single pair **11** of holding elements **13.** The shown single pair **11** (single set) of holding elements **13** is used for description purposes only. It is evident to a person skilled in the art that the inventive mounting structure **3** should not be limited to a single pair **11** (single set) of holding elements **13** (snaps). Furthermore, a certain profile of the holding elements **13,** a certain width of the holding elements **13** or a certain distance **15D** between the pair **11** of holding elements **13** should not be regarded as a limitation of the invention.

As mentioned already in the description of Fig 2, the plurality of pairwise arranged support elements **6,** the alignment support **7,** the single pair **11** of holding elements **13,** a limit stop **10** and the seats **32** for each electric lead **30** of the capacitor **4** and an arc shaped guide **34** are formed as integral parts of the bottom **5** of the housing part **9,** which at least define the mounting structure **3.**

According to the invention, the arc shaped guide **34** is moulded-in the bottom **5** of the housing part **9** and oriented in the X-direction **X.** According to the invention, a surface form **34S** of the arc shaped guide **34** continues into a surface form **6S** of the support elements **6.** The holding elements **13** are elastic and can deflect in opposing Y-directions **Y.** The deflection of the holding elements **13** is initiated by the insertion of the capacitor **4** between the holding elements **13.**

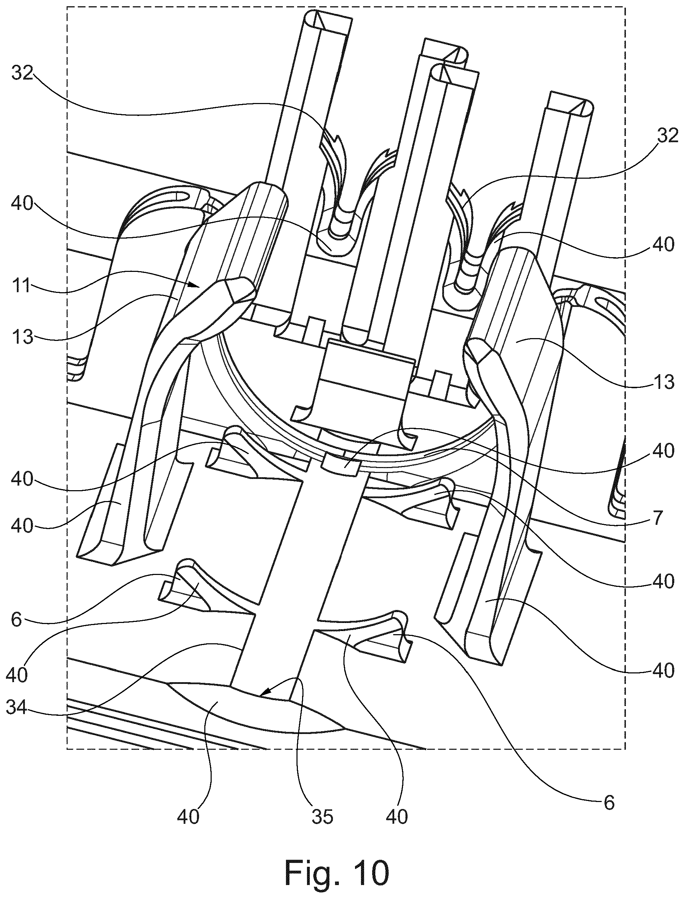

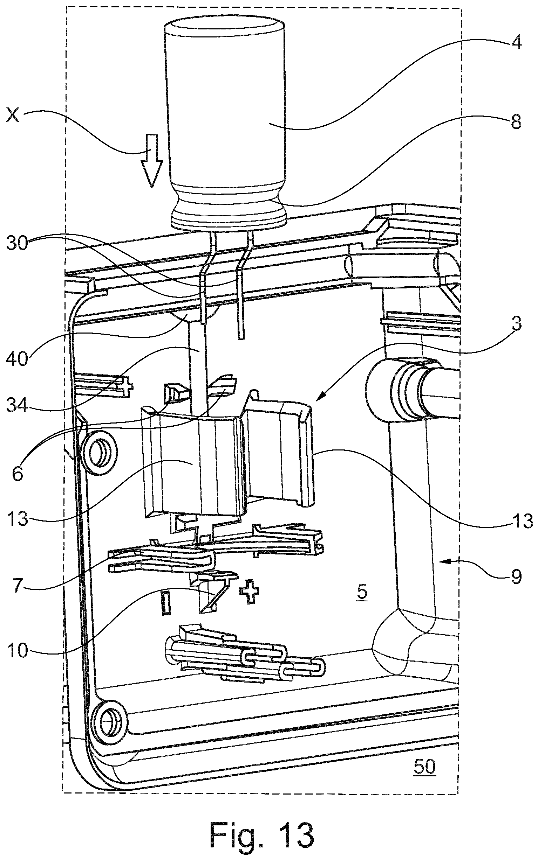

**Figure 10** is an enlarged perspective view of the mounting structure **3** (cradle) as shown in Fig. 9 with chamfers **40** for guiding and inserting the capacitor **4** into the housing part **9** with the mounting structure **3.** According to a preferred embodiment there is a chamfer **40** at a free end **35** of the arc shaped guide **34,** wherein the chamfer **40** is formed as well in the bottom **5** of a housing part **9.** Another chamfer **40** is provided at each of the pairwise arranged support elements **6.** Furthermore, a chamfer **40** is provided at each of the holding elements **13** (snaps) of the mounting structure **3.** Additionally, a chamfer **40** is provided at the alignment support **7.** According to the embodiment shown in Fig. 10 a chamfer **40** is formed at each seat **32** for each electric lead **30** (see Fig. 13) of the capacitor **4.** The chamfers **40** help to guide the capacitor **4** in the mounting structure **3** (for example between the holding elements **13)** and help to guide the electric leads **30** of the capacitor **4** into the respective seats **32.** It is evident for a person skilled in the art, that the shape and form the chamfers **40** show in Fig. 10 should not be regarded as a limitation. For example, bigger chamfers **40** or alternative features can be applied to better guide the leads **30** of the capacitor **4** into the seats **32** in case stumbling of the electric leads **30** of the capacitor **4** is considered a risk.

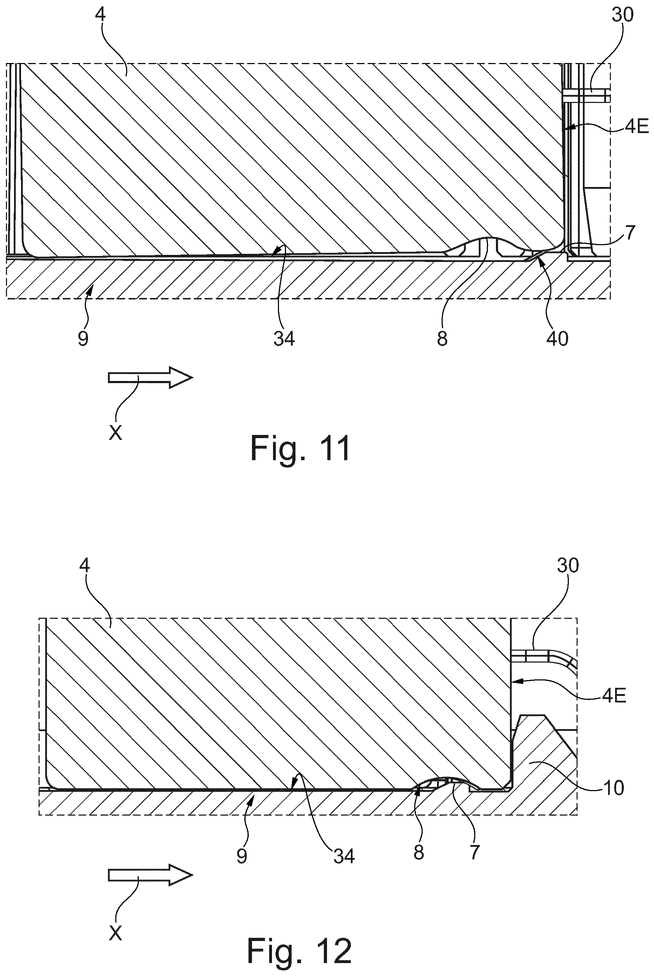

**Figure 11** is an enlarged side view of the capacitor **4** during the insertion process into the mounting structure **3** (cradle). As mentioned above the chamfers **40** help that the capacitor **4** slides smoothly along the X-direction **X** in guide **34** and into the mounting structure **3** (cradle). When the front end **4E** of the capacitor **4** reaches the alignment support **7,** which can have the form of a T-shaped rib, a chamfer **40,** for example in the form of small ramp, helps the capacitor **4** not to stumble and climb the little step.

**Figure 12** is an enlarged side view of capacitor **4** which is in the end position in the mounting structure **3** (cradle). The holding elements **13** (snaps), not shown here, are elastic and allow the front end **4E** of the capacitor **4** to pass the small 'obstacle'. As soon as the circumferential notch **8** of the capacitor **4** reaches the alignment support **7,** forced by the elastic force stored in the holding elements **13,** the capacitor **4** returns in contact with the guide **34** and reaches the final position by touching the limit stop **10** with the front end **4E.** In the final position the alignment support **7** engages the circumferential notch **8** of the capacitor **4.**

**Figure 13** is a perspective front view of the mounting structure **3** (cradle) as shown in Fig. 8, with a capacitor **4** in a position to be mounted to the mounting structure **3** of the housing part **9.** The assembly takes place with the housing part **9** placed on a jig surface **50** wherein the bottom **5** of the housing part **9** is oriented at an angle between 70° to 90°, preferably perpendicular, to the jig surface **50.** The capacitor **4** comes down along the X-direction **X,** which is parallel to the guide **34** in the bottom **5** of the housing part **9.**

During the movement the capacitor **4** reaches at first the chamfer **40** of the guide **34** and then the chamfer **40** of the support elements **6** and the chamfers **40** of the holding elements **13.** The chamfers **40** help to center and orient the capacitor **4** so that a smooth insertion of the capacitor **4** between the holding elements **13** is achieved. The capacitor **4** is centred with respect to the arc shaped guide **34.** Finally, the front end **4E** of the capacitor **4** abuts against the limit stop **10** and the alignment support **7** engages the circumferential notch **8** of the capacitor **4** (see description of Fig. 12).

It is believed that the present disclosure and many of its attendant advantages will be understood by the foregoing description, and it will be apparent that various changes may be made in the form, construction, number and arrangement of the components without departing from the disclosed subject matter or without sacrificing all of its material advantages. The form described is merely explanatory, and it is the intention of the following claims to encompass and include such changes. Accordingly, the scope of the invention should be limited only by the claims appended hereto.

### List of Reference Numerals

- 1: Electronic control unit (ECU)
- 2: Housing
- 3: Mounting structure, cradle
- 4: Capacitor
- 4D: Capacitor diameter
- 4E: Front end
- 5: Bottom
- 6: Support elements
- 6S: Surface form
- 7: Alignment support
- 8: Circumferential notch
- 9: Housing part
- 10: Limit stop
- 11: Pair
- 13: Holding element
- 14: Free end
- 15: Nose
- 15D: Distance
- 16: Vehicle
- 18: Vehicle battery
- 19: Electric line
- 20: Surface
- 22: Area
- 24: Gap
- 30: Electric lead
- 32: Seat
- 34: Guide
- 34S: Surface form
- 35: Free end
- 40: Chamfer
- 50: Jig surface
- A1: holding element
- A2: holding element
- B1: holding element
- B2: holding element
- X: X-direction
- Y: Y-direction
- Z: Z-direction

## Claims

1. A mounting structure (3) for a capacitor (4) in a housing part (9), comprising:
an arc shaped guide (34), a plurality of pairwise arranged support elements (6), an alignment support (7), at least one pair (11) of holding elements (13), a limit stop (10) and a seat (32) for each electric lead (30) of the capacitor (4) formed on a bottom (5) of a housing part (9),
**characterized by**
a chamfer (40) at a free end (35) of the arc shaped guide (34) which is formed in the bottom (5) of a housing part (9);
a chamfer (40) at each of the pairwise arranged support elements (6);
a chamfer (40); at each of the of holding elements (13); and
a chamfer (40) at the alignment support (7),
the arc shaped guide (34) being oriented in an X-direction (X), which is parallel to the axis of the capacitor (4) and formed in the bottom (5) of the housing part (9),
the pairwise arranged support elements (6) being provided adjacent to the sides of the arc shaped guide (34),
each of holding elements (13) deflecting in antipodal Y-directions upon insertion of the capacitor (4) between said at least one pair (11) of holding elements (13), and
a surface form (34S) of the arc shaped guide (34) continuing into a surface form (6S) of the support elements (6).

2. The mounting structure (3) according to claim 1, wherein a chamfer (40) is provided at each seat (32) for each electric lead (30) of the capacitor (4).

3. The mounting structure (3) according to anyone of the preceding claims, wherein all the chamfers (40) of the mounting structure (3) face in the direction of the free end of the arc shaped guide (34).

4. The mounting structure (3) according to claim 1, wherein the arc shaped guide (34) is arranged between the at least one pair (11) of holding elements (13) and moulded-in the bottom (5) of the housing part (9).

5. The mounting structure (3) according to anyone of the preceding claims, wherein the holding elements (13) are elastic and upon insertion of the capacitor (4) in X-direction (X), the holding elements (13) deflect in opposing Y-directions (Y).

6. The mounting structure (3) according to anyone of the preceding claims, wherein a single pair (11) of holding elements (13) are part of the mounting structure.

7. The mounting structure (3) according to anyone of the preceding claims, wherein the limit stop (10) is a stop for the capacitor (4) when inserted between the at least one pair (11) of holding elements (13) and the alignment support (7) engages a circumferential notch (8) of the capacitor (4).

8. An electronic control unit (1) for a vehicle (16) incorporating a mounting structure (3) for a capacitor (4) in a housing part (9) of the electronic control unit (1), wherein the mounting structure (3) is claimed in anyone of the preceding claims.

9. A method for mounting a capacitor (4) to a mounting structure (3) of a housing part (9) according to claim 1, comprising the steps of:
• placing the housing part (9) on a jig surface (50) such that a bottom (5) of the housing part (9) is perpendicular to the jig surface (50);
• moving the capacitor (4) along an X-direction (X);
• centring and sliding the capacitor (4) with the help of a chamfer (40) at a free end of an arc shaped guide (34), the chamfers (40) of the support elements (6) and the chamfers (40) of the at least one pair (11) of holding elements (13) of the mounting structure (3);
• moving the capacitor (4) in the X-direction (X) between the at least one pair (11) of holding elements (13) towards a limit stop (10) and thereby elastically deforming the holding elements (13) in antipodal Y-directions (Y); and
• abutting the capacitor (4) at a limit stop (10), and thereby an alignment support (7) of the mounting structure (3) of the housing part (9) engages a circumferential notch (8) of the capacitor (4).

10. Method for mounting a capacitor (4) as claimed in claim 9, wherein the capacitor (4) moves up a chamfer (40) of an alignment support (7) which is part of the mounting structure (3) of the housing part (9) and the capacitor (4) is forced by the elastic force, stored in the holding elements (13), so that the alignment support (7) gets in contact with the circumferential notch (8) of the capacitor (4) once the front end (4E) of the capacitor (4) touches the limit stop (10).

11. Method for mounting a capacitor (4) as claimed in claim 9, wherein electric leads (30) of the capacitor (4) are guided via chamfers (4) at each seat (32) into each seat (32).

## Patentansprüche

1. Eine Montagestruktur (3) für einen Kondensator (4) in einem Gehäuseteil (9), umfassend:
eine bogenförmige Führung (34), eine Vielzahl von paarweise angeordneten Stützelementen (6), eine Ausrichtungsstütze (7), mindestens ein Paar (11) von Halteelementen (13), einen Endanschlag (10) und einen Sitz (32) für jede elektrische Anschlussleitung (30) des Kondensators (4), der an einem Boden (5) eines Gehäuseteils (9) ausgebildet ist,
**gekennzeichnet durch**
eine Fase (40) an einem freien Ende (35) der bogenförmigen Führung (34), die im Boden (5) eines Gehäuseteils (9) ausgebildet ist;
eine Fase (40) an jedem der paarweise angeordneten Stützelemente (6);
eine Fase (40) an jedem der Halteelemente (13); und
eine Fase (40) an der Ausrichtungsstütze (7),
wobei die bogenförmige Führung (34) in einer X-Richtung (X) ausgerichtet ist, die parallel zur Achse des Kondensators (4) verläuft und im Boden (5) des Gehäuseteils (9) ausgebildet ist,
wobei die paarweise angeordneten Stützelemente (6) angrenzend an die Seiten der bogenförmigen Führung (34) vorgesehen sind,
wobei sich jedes der Halteelemente (13) beim Einführen des Kondensators (4) zwischen dem mindestens einen Paar (11) von Halteelementen (13) in entgegengesetzte Y-Richtungen auslenkt, und
wobei eine Oberflächenform (34S) der bogenförmigen Führung (34) in eine Oberflächenform (6S) der Stützelemente (6) übergeht.

2. Die Montagestruktur (3) nach Anspruch 1, wobei an jedem Sitz (32) für jede elektrische Anschlussleitung (30) des Kondensators (4) eine Fase (40) vorgesehen ist.

3. Die Montagestruktur (3) nach einem der vorstehenden Ansprüche, wobei alle Fasen (40) der Montagestruktur (3) in die Richtung des freien Endes (35) der bogenförmigen Führung (34) weisen.

4. Die Montagestruktur (3) nach Anspruch 1, wobei die bogenförmige Führung (34) zwischen dem mindestens einen Paar (11) von Halteelementen (13) angeordnet und in den Boden (5) des Gehäuseteils (9) eingegossen ist.

5. Die Montagestruktur (3) nach einem der vorstehenden Ansprüche, wobei die Halteelemente (13) elastisch sind und sich die Halteelemente (13) beim Einsetzen des Kondensators (4) in X-Richtung (X) in entgegengesetzte Y-Richtungen (Y) auslenken.

6. Die Montagestruktur (3) nach einem der vorstehenden Ansprüche, wobei ein einzelnes Paar (11) von Halteelementen (13) Teil der Montagestruktur (3) ist.

7. Die Montagestruktur (3) nach einem der vorstehenden Ansprüche, wobei der Endanschlag (10) einen Anschlag für den Kondensator (4) darstellt, wenn dieser zwischen dem mindestens einen Paar (11) von Halteelementen (13) eingesetzt ist, und die Ausrichtungsstütze (7) in eine umlaufende Kerbe (8) des Kondensators (4) eingreift.

8. Ein elektronisches Steuergerät (1) für ein Fahrzeug (16), das eine Montagestruktur (3) für einen Kondensator (4) in einem Gehäuseteil (9) des elektronischen Steuergeräts (1) umfasst, wobei die Montagestruktur (3) gemäß einem der vorstehenden Ansprüche beansprucht ist.

9. Ein Verfahren zum Montieren eines Kondensators (4) an einer Montagestruktur (3) eines Gehäuseteils (9) nach Anspruch 1, mit den folgenden Schritten:
• Anordnen des Gehäuseteils (9) auf einer Montagegestellfläche (50) derart, dass ein Boden (5) des Gehäuseteils (9) senkrecht zur Montagegestellfläche (50) steht;
• Bewegen des Kondensators (4) entlang einer X-Richtung (X);
• Zentrieren und Verschieben des Kondensators (4) mithilfe einer Fase (40) an einem freien Ende (35) einer bogenförmigen Führung (34), der Fasen (40) der Stützelemente (6) und der Fasen (40) des mindestens einen Paares (11) von Halteelementen (13) der Montagestruktur (3);
• Bewegen des Kondensators (4) in X-Richtung (X) zwischen dem mindestens einen Paar (11) von Halteelementen (13) in Richtung eines Endanschlags (10) und dadurch elastisches Verformen der Halteelemente (13) in antipodalen Y-Richtungen (Y); und
• Anlegen des Kondensators (4) an einen Endanschlag (10), wodurch eine Ausrichtungsstütze (7) der Montagestruktur (3) des Gehäuseteils (9) in eine umlaufende Kerbe (8) des Kondensators (4) eingreift;

10. Das Verfahren zum Montieren eines Kondensators (4) nach Anspruch 9, wobei sich der Kondensator (4) an einer Fase (40) einer Ausrichtungsstütze (7), die Teil der Montagestruktur (3) des Gehäuseteils (9) ist, nach oben bewegt und der Kondensator (4) durch die in den Halteelementen (13) gespeicherte elastische Kraft derart beaufschlagt wird, dass die Ausrichtungsstütze (7) mit der umlaufenden Kerbe (8) des Kondensators (4) in Kontakt kommt, sobald das vordere Ende (4E) des Kondensators (4) den Endanschlag (10) berührt.

11. Das Verfahren zum Montieren eines Kondensators (4) nach Anspruch 9, wobei elektrische Anschlussleitungen (30) des Kondensators (4) über Fasen (40) an jedem Sitz (32) in den jeweiligen Sitz (32) geführt werden.

## Revendications

1. Une structure de fixation (3) pour un condensateur (4) dans une partie de boîtier (9), comprenant :
un guide en forme d'arc (34), une pluralité d'éléments de support (6) disposés par paires, un support d'alignement (7), au moins une paire (11) d'éléments de retenue (13), une butée (10) et un logement (32) pour chaque conduite électrique (30) du condensateur (4), formée sur un fond (5) d'une partie de boîtier (9),
**caractérisé par**
un chanfrein (40) au niveau d'une extrémité libre (35) du guide en forme d'arc (34) qui est formé dans le fond (5) d'une partie de boîtier (9) ;
un chanfrein (40) au niveau de chacun des éléments de support (6) disposés par paires ;
un chanfrein (40) au niveau de chacun des éléments de retenue (13) ; et
un chanfrein (40) au niveau du support d'alignement (7),
le guide en forme d'arc (34) étant orienté dans une direction X (X), qui est parallèle à l'axe du condensateur (4) et formé dans le fond (5) de la partie de boîtier (9),
les éléments de support (6) disposés par paires étant prévus à proximité des côtés du guide en forme d'arc (34),
chacun des éléments de retenue (13) se déviant dans des directions Y opposées lors de l'insertion du condensateur (4) entre ladite au moins une paire (11) d'éléments de retenue (13), et
une forme de surface (34S) du guide en forme d'arc (34) se prolongeant en une forme de surface (6S) des éléments de support (6).

2. La structure de fixation (3) selon la revendication 1, dans laquelle un chanfrein (40) est prévu au niveau de chaque logement (32) pour chaque conduite électrique (30) du condensateur (4).

3. La structure de fixation (3) selon l'une quelconque des revendications précédentes, dans laquelle tous les chanfreins (40) de la structure de fixation (3) sont orientés en direction de l'extrémité libre (35) du guide en forme d'arc (34).

4. La structure de fixation (3) selon la revendication 1, dans laquelle le guide en forme d'arc (34) est disposé entre la au moins une paire (11) d'éléments de retenue (13) et moulé dans le fond (5) de la partie de boîtier (9).

5. La structure de fixation (3) selon l'une quelconque des revendications précédentes, dans laquelle les éléments de retenue (13) sont élastiques et, lors de l'insertion du condensateur (4) dans la direction X (X), les éléments de retenue (13) dévient (se déforment) dans des directions Y opposées (Y).

6. La structure de fixation (3) selon l'une quelconque des revendications précédentes, dans laquelle une seule paire (11) d'éléments de retenue (13) fait partie de la structure de fixation (3).

7. La structure de fixation (3) selon l'une quelconque des revendications précédentes, dans laquelle la butée (10) sert de butée pour le condensateur (4) lorsqu'il est inséré entre la au moins une paire (11) d'éléments de retenue (13) et le support d'alignement (7) s'engage dans une encoche circonférentielle (8) du condensateur (4).

8. Une unité de commande électronique (1) pour un véhicule (16) comprenant une structure de fixation (3) pour un condensateur (4) dans une partie de boîtier (9) de l'unité de commande électronique (1), dans laquelle la structure de fixation (3) est celle revendiquée dans l'une quelconque des revendications précédentes.

9. Un procédé d'assemblage d'un condensateur (4) sur une structure de fixation (3) d'une partie de boîtier (9) selon la revendication 1, comprenant les étapes consistant à :
• placer la partie de boîtier (9) sur une surface de gabarit (50) de telle sorte qu'un fond (5) de la partie de boîtier (9) soit perpendiculaire à la surface de gabarit (50) ;
• déplacer le condensateur (4) le long d'une direction X (X) ;
• centrer et coulisser le condensateur (4) à l'aide d'un chanfrein (40) situé à une extrémité libre (35) d'un guide en forme d'arc (34), des chanfreins (40) des éléments de support (6) et des chanfreins (40) de la au moins une paire (11) d'éléments de retenue (13) de la structure de fixation (3) ;
• déplacer le condensateur (4) dans la direction X (X) entre la au moins une paire (11) d'éléments de retenue (13) vers une butée (10) et, ce faisant, déformer élastiquement les éléments de retenue (13) dans des directions Y antipodales (Y) ; et
• mettre en butée du condensateur (4) contre une butée de fin de course (10), ce qui fait qu'un support d'alignement (7) de la structure de fixation (3) de la partie de boîtier (9) s'engage dans une encoche circonférentielle (8) du condensateur (4).

10. Le procédé d'assemblage d'un condensateur (4) selon la revendication 9, dans lequel le condensateur (4) remonte le long d'un chanfrein (40) d'un support d'alignement (7) qui fait partie de la structure de fixation (3) de la partie de boîtier (9) et le condensateur (4) est poussé par la force élastique stockée dans les éléments de retenue (13), de sorte que le support d'alignement (7) entre en contact avec l'encoche circonférentielle (8) du condensateur (4) dès que l'extrémité avant (4E) du condensateur (4) touche la butée (10).

11. Le procédé d'assemblage d'un condensateur (4) selon la revendication 9, dans lequel les conduites électriques (30) du condensateur (4) sont guidées via des chanfreins (40) au niveau de chaque logement (32) pour être introduits dans chaque logement (32).
